Europäisches Patentamt

European Patent Office

Office européen des brevets

(11) Numéro de publication: **0 517 335 A1**

## DEMANDE DE BREVET EUROPEEN

(21) Numéro de dépôt: **92201606.8**

(22) Date de dépôt: **04.06.92**

(51) Int. Cl.⁵: **H03K 23/66**

(30) Priorité: **07.06.91 FR 9106928**

(43) Date de publication de la demande:
**09.12.92 Bulletin 92/50**

(84) Etats contractants désignés:
**DE FR GB**

(71) Demandeur: **PHILIPS COMPOSANTS**
**117, quai du Président Roosevelt**
**F-92130 Issy les Moulineaux(FR)**

(84) **FR**

(71) Demandeur: **N.V. Philips'**
**Gloeilampenfabrieken**
**Groenewoudseweg 1**
**NL-5621 BA Eindhoven(NL)**

(84) **DE GB**

(72) Inventeur: **Gorisse, Philippe, Société Civile**
**S.P.I.D.**
**156, Boulevard Haussmann**
**F-75008 Paris(FR)**

(74) Mandataire: **Pinchon, Pierre**
**Société Civile S.P.I.D. 156, Boulevard**
**Haussmann**
**F-75008 Paris(FR)**

(54) **Circuit diviseur de fréquences.**

(57) Circuit diviseur de fréquence programmable comportant un prédiviseur à p cellules de division en cascade où chaque cellule de rang i fournit un rapport de division normal de 2 et est programmable pour pouvoir également diviser par 3, la fréquence d'entrée appliquée à cette cellule.

Selon l'invention, chaque cellule de rang i fournit, en tant que signal d'autorisation du mode programmé, destiné à la cellule de rang i-1 qui la précède, un signal dit de fenêtre, calibré en durée et en position dans le temps, à la fréquence de travail de ladite cellule i, et le prédiviseur (PPSC) est associé à des moyens de comptage (CNT) pour fournir un rapport de division (R) programmable égal à $M.2^p + N$ pour lequel M est un nombre entier fourni aux moyens de comptage (CNT), p est le nombre de cellules du prédiviseur (PPSC), et N est un nombre entier fourni aux entrées de programmation du prédiviseur (PPSC).

FIG.7

La présente invention a pour objet un circuit diviseur de fréquence programmable comportant:

p cellules de division de fréquence disposées en cascade, chacune de ces cellules représentant un rang de division i, pour i prenant l'une des valeurs de 0 à (p-1), et étant susceptible d'être commutée entre un mode de division par deux, dit mode normal, et un mode de division par trois, dit mode programmé, une cellule de rang quelconque i comportant une première entrée ($I_i$) pour un signal de fréquence d'entrée ($FI_i$) et une première sortie ($O_i$) pour un signal de fréquence de sortie ($FO_i$) à appliquer à la première entrée ($I_{i+1}$) de la cellule suivante de rang ($i+1$), une deuxième entrée ($CI_i$) pour un signal d'autorisation du mode programmé, une troisième entrée ($D_i$) pour un signal de programmation, et une deuxième sortie ($CO_i$) pour un signal de fenêtre, des moyens étant prévus pour engendrer ce signal de fenêtre à partir du signal d'autorisation reçu sur la deuxième entrée ($CI_i$) de la cellule i et ce signal de fenêtre étant appliqué à la deuxième entrée ($CI_{i-1}$) de la cellule (i-1) de rang inférieur, en tant que signal d'autorisation,

Un circuit diviseur de fréquence de ce type est connu du document FR-A-2 653 617. Selon ce document, le circuit diviseur de fréquence programmable comporte une pluralité p de cellules de division disposées en cascade, chacune de ces cellule étant susceptible d'effectuer une division de fréquence d'entrée de la cellule par deux ou encore par trois selon la valeur des signaux appliqués d'une part sur la troisième entrée dite de programmation ($D_i$) et d'autre part sur la deuxième entrée $CI_i$ dite d'autorisation de la même cellule. Pour un facteur de division déterminé, des signaux appropriés sont appliqués en permanence sur les entrées de programmation ($D_i$) alors que c'est un signal d'autorisation reçu sur la deuxième entrée $CI_i$ de chaque cellule qui détermine à quel moment la cellule en question doit effectuer le mode de division dit programmé, c'est-à-dire une division par trois au lieu de deux dans le mode normal. Chaque cellule recevant un signal d'autorisation transmet à la cellule qui la précède, un signal dit de fenêtre qui est reçu par cette cellule précédente en tant que signal d'autorisation.

Le circuit diviseur de fréquence connu présente un certain nombre de limitations. D'une part, la plage des valeurs des facteurs de division qu'un tel circuit est susceptible d'opérer est assez limitée (elle dépend du nombre de cellules), du fait que le signal d'autorisation appliqué à la $p^{ième}$ cellule, c'est-à-dire la dernière de la série, est en fait un signal invariable et plus précisément un signal à l'état bas. L'entrée d'autorisation correspondante est en effet mise à la masse. D'autre part, dans le circuit connu, chacune des cellule de division produit un signal de fenêtre destiné à la cellule qui la précède qui est fixé par le propre rythme de cette cellule en ce qui concerne le passage à l'état logique actif de ce signal de fenêtre, tandis que le retour à l'état logique inactif de ce même signal de fenêtre est transmis directement à toutes les cellules, simultanément, par l'effet d'une porte OU prévue dans chaque cellule de ce circuit. Or ce signal subit nécessairement un retard en traversant les p cellules du circuit alors que la plus grande précision est nécessaire en ce qui concerne la première cellule qui travaille à la fréquence la plus élevée.

La présente invention à pour but de s'affranchir de ces limitations.

A cet effet, un circuit diviseur de fréquence selon l'invention est caractérisé en ce que les moyens pour engendrer le signal de fenêtre sont agencés pour que ce signal soit émis à partir de l'instant où le signal d'autorisation reçu par la même cellule i, retourne à son état logique inactif, et en ce qu'aux p cellules - qui constituent un prédiviseur pour le circuit diviseur de fréquence - sont associés des moyens de comptage pour effectuer un premier comptage et un second comptage respectivement d'un premier nombre et d'un second nombre de périodes de la fréquence de sortie dudit prédiviseur, la deuxième entrée ($CI_{p-1}$) de la pème cellule recevant un signal d'autorisation délivré par les moyens de comptage, qui est déduit de l'achèvement dudit premier comptage, et l'accomplissement de ces premier et second comptages constituant une période de sortie du circuit diviseur.

Dans les circuits diviseurs de fréquence, on désigne par "avalement" d'une période de la fréquence d'entrée, l'opération qui résulte du fait qu'une cellule, lorsqu'elle est programmée et commandée pour diviser par 3, "avale" sans réagir une période supplémentaire de sa fréquence d'entrée, par comparaison avec le mode normal, (non programmé) dans lequel elle divise par 2 sa fréquence d'entrée.

Du fait que le circuit diviseur selon l'invention associe un prédiviseur formé de p cellules de division programmables en cascade, avec des moyens de comptage permettant d'augmenter de manière programmable le facteur de division obtenu à la sortie du prédiviseur, ce circuit selon l'invention a une plage de facteur de division plus étendue que celle du circuit connu. Par ailleurs le signal de fenêtre généré par une cellule quelconque du prédiviseur n'est engendré que lorsque son propre signal d'autorisation retourne à son état logique inactif, ou encore un court instant après. De la sorte, le signal d'autorisation reçu par une cellule quelconque de rang i se trouve déterminé aussi bien au départ de son étant logique actif qu'à son retour à l'état logique inactif par la cellule qui la suit et ce signal possède donc la précision de cette cellule de rang i + 1. Ceci présente le très grand avantage que, en remontant la série des p cellules en cascade à partir de la dernière jusqu'à la première, la précision nécessaire pour les signaux de fenêtre (qui sont en même temps les signaux d'autorisation reçus par la cellule voisine) ne nécessitent une précision temporelle pas plus élevée que la précision requise au sein de cette cellule travaillant à sa propre fréquence d'entrée. En d'autres termes, les signaux de fenêtre sont recalibrés à une échelle de temps de plus en plus précise en partant de la dernière cellule vers la première cellule du prédiviseur.

En effet, le signal d'autorisation d'avalement émis par les moyens de comptage est à une fréquence relativement basse correspondant à la fréquence de sortie du prédiviseur, cette liaison n'est donc pas critique. Les signaux dits de fenêtre, émis par chaque cellule pour servir de signal d'autorisation destiné à la cellule qui la précède, est à une fréquence qui croît en allant de la $p^e$ cellule vers la $2^e$ cellule. La liaison la plus critique en temps de réponse (pour la commande d'autorisation de la $1^{ère}$ cellule) se trouve donc située entre la $2^e$ et la $1^{ère}$ cellule, cellules qui sont naturellement disposées côte-à-côte et peuvent être alimentées avec les courants les plus élevés. Les cellules qui suivent, fonctionnant à fréquences de plus en plus basses, peuvent être alimentées par des courants de plus en plus réduits. Pour cette raison le circuit diviseur de fréquence selon l'invention est apte à recevoir un signal de fréquence d'entrée plus élevé que celui de l'art antérieur.

Le circuit selon l'invention est aussi plus aisé à mettre au point et ne comporte pas de liaison qui soit à la fois de grande longueur et critique en temps de réponse, comme c'est le cas du circuit connu où une liaison critique doit commander la cellule d'entrée du prédiviseur à partir de sa cellule de sortie et à travers toutes les autres cellules qui constituent le prédiviseur.

Selon un mode préféré et avantageux de mise en oeuvre de l'invention, le circuit diviseur est caractérisé en ce que lesdits moyens de comptage étant chargés par un compte total M (avec M = variable entière, plus grande que 1) ledit premier nombre est égal à (M - 1) durant le comptage duquel les p cellules du prédiviseur fonctionnent en mode non programmé et les entrées de programmation peuvent être rechargées tandis que ledit second nombre est égal à 1, correspondant à une période de la fréquence de sortie du prédiviseur dont les cellules fonctionnent alors en mode programmé, période durant laquelle les moyens de comptage sont rechargés au compte M. Dans ce mode de mise en oeuvre, les moyens de comptage peuvent se réduire aisément à un seul compteur ce qui réduit en conséquence la complexité et l'encombrement du circuit diviseur.

Le signal de fenêtre généré par une cellule de rang i, présente de préférence une durée comprise entre 0,5 et 1,5 fois la période de la fréquence d'entrée ($FI_i$) de cette même cellule.

Dans un mode pratique et avantageux de mise en oeuvre de l'invention, le circuit diviseur est caractérisé en ce que chacune des cellules du prédiviseur comporte une première et une deuxième bascule de type D en cascade et cadencées respectivement par le signal de fréquence d'entrée ($FI_i$) de cette cellule, et son inverse logique, en ce que la sortie de la deuxième bascule est rebouclée sur l'entrée de données de la première bascule, la sortie de la première bascule constituant la première sortie ($O_i$) de la cellule, et en ce qu'elle comporte un étage de maintien entre la sortie de la deuxième bascule et l'entrée de données de la première bascule qui inclut ladite entrée de programmation ($D_i$) de la cellule, étage de maintien agencé pour forcer l'état de l'entrée de données (D) de la première bascule en vue d'un avalement lorsque les signaux de programmation d'avalement ($D_i$) et d'autorisation ($CI_i$) sont actifs simultanément.

L'avalement d'une période de la fréquence d'entrée d'une cellule quelconque peut être obtenu du fait que l'étage de maintien comporte une troisième bascule D cadencée par le signal de fréquence d'entrée ($FI_i$), dont l'entrée de données reçoit l'inverse logique du signal de la sortie de la deuxième bascule et dont la sortie est connectée à une première porte OU, inverseuse, la deuxième entrée de cette porte OU constituant ladite deuxième entrée ($CI_i$) de la cellule, laquelle porte OU a sa sortie connectée à l'entrée de données d'une quatrième bascule D cadencée par l'inverse du signal de fréquence d'entrée ($FI_i$) et dont la sortie est rebouclée sur l'entrée de la première bascule du fait que cette sortie est connectée à une première entrée d'une porte ET dont l'autre entrée constitue ladite entrée de programmation ($D_i$) de la cellule, et que la sortie de la porte ET est connectée à une première entrée d'une deuxième porte OU, dont la sortie est connectée à l'entrée de la première bascule, la deuxième entrée de la deuxième porte OU recevant le signal de la sortie de la deuxième bascule pour réaliser ledit rebouclage de cette sortie sur l'entrée de la première bascule.

Avantageusement, chaque cellule du prédiviseur comporte en outre une cinquième bascule D cadencée par le signal de fréquence d'entrée ($FI_i$), dont l'entrée de données reçoit l'inverse logique de la sortie de la quatrième bascule, la sortie de la cinquième bascule constituant ladite deuxième sortie ($CO_i$) de la cellule.

L'invention sera mieux comprise à la lecture de la description qui va suivre, donnée à titre d'exemple non limitatif, en liaison avec les dessins qui représentent :

- la figure 1, une portion du circuit diviseur de fréquence selon l'invention qui est similaire au circuit diviseur connu.
- la figure 2, un chronogramme relatif à la portion de circuit de la figure 1, fonctionnant conformément à l'invention.
- la figure 3, un mode de réalisation selon l'invention d'une cellule du prédiviseur de la figure 2 et les figures 4a et 4b, des chronogrammes correspondants,
- la figure 5, trois cellules adjacentes et la figure 6, des chronogrammes correspondants,
- la figure 7, un circuit diviseur de fréquence selon l'invention,
- la figure 8, un mode de réalisation des moyens de comptage liés à la partie finale du prédiviseur de la figure 1, et la figure 9, un chronogramme correspondant.

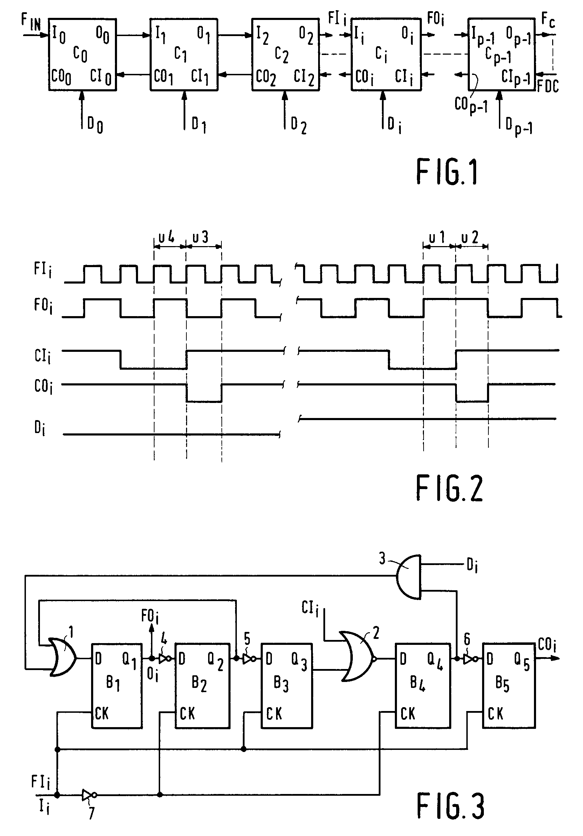

La figure 1 représente de manière schématique l'organisation d'un prédiviseur à p cellules dans le circuit diviseur de fréquence de l'invention qui est sensiblement identique à celle du circuit connu. Sur cette figure chaque cellule est affectée d'un indice correspondant à son rang de poids qui va de 0 pour la cellule d'entrée, à (p - 1) pour la cellule de sortie du prédiviseur. Chaque cellule de division (d'ordre i pour une cellule quelconque) comporte une entrée $I_i$ pour un signal de fréquence d'entrée $FI_i$ et une sortie $O_i$ pour un signal de fréquence de sortie $FO_i$, ainsi qu'une entrée de programmation $D_i$. Une entrée $CI_i$ a pour fonction de recevoir un signal d'autorisation d'avalement (signal également noté $CI_i$), pour une période supplémentaire de la fréquence d'entrée $FI_i$, avalement qui est effectué lorsque l'entrée de programmation $D_i$ est au niveau 1, et se trouve bloqué lorsque l'entrée de programmation $D_i$ est au niveau 0. Le signal de programmation d'avalement lui-même est également noté $D_i$ sur la figure. Une sortie $CO_i$ produit un signal de fenêtre qui sert de signal d'autorisation d'avalement pour la cellule de rang de poids (i - 1) qui précède la cellule en question. La cellule de rang de poids zéro ($C_0$) ou cellule d'entrée, reçoit à son entrée $I_0$ la fréquence $F_{IN}$ à diviser. La sortie $O_o$ de la cellule de rang zéro est connectée à l'entrée $I_1$ de la cellule de rang de poids 1 et ainsi de suite jusqu'à la cellule de rang (p - 1) dont l'entrée $I_{p-1}$ reçoit le signal de la sortie $O_{p-2}$ de la cellule de rang de poids (p - 2). La sortie $O_{p-1}$ de la cellule de sortie du prédiviseur délivre un signal $F_c$. L'entrée $CI_{p-1}$ de cette cellule de sortie reçoit un signal FDC d'autorisation d'avalement qui met cette cellule en mode de programmation pour une durée d'une seule période de sa fréquence de sortie. La sortie $CO_{p-1}$, connectée à l'entrée $CI_{p-2}$ de la cellule de rang de poids (p - 2), produit ensuite un signal de fenêtre généré à partir du signal FDC, processus qui est répété d'une cellule à la précédente jusqu'à la cellule de rang zéro, dont l'entrée $CI_0$ reçoit le signal de la sortie $CO_1$ de la cellule de rang 1. En d'autres termes, le signal de fréquence $FI_i$ dont la fréquence est successivement divisée, se propage de la cellule de rang zéro jusqu'à celle de rang (p - 1), alors que le signal d'autorisation d'avalement, dont la fréquence est successivement multipliée, se propage à contre-courant depuis la cellule de rang (p - 1) jusqu'à la cellule de rang zéro.

Si la configuration de cellules de division représentée à la figure 1 est sensiblement identique à celle indiquée dans le document FR-A-2 653 617, cité plus haut, son fonctionnement, selon la présente invention, présente des différences qui vont être expliquées au moyen de la figure 2.

Le chronogramme des signaux de la figure 2 illustre la situation pour une cellule quelconque d'ordre i dans l'hypothèse d'une division nominale par 2, ($D_i = 0$), ou d'une division par 3 en mode programmé, ($D_i = 1$). Pour $D_i = 0$ (partie gauche du dessin), $FO_i$ résulte d'une division par deux du signal $FI_i$ même en présence d'un signal d'autorisation d'avalement ($CI_i = 0$). Par contre pour $D_i = 1$ (partie droite du dessin), la présence d'un signal d'autorisation d'avalement ($CI_i = 0$) a pour effet que $FO_i$ reste au niveau haut pendant un intervalle supplémentaire égal à une période de la fréquence $FI_i$, ce qui correspond bien à une division par trois de la fréquence d'entrée $FI_i$. Le signal de fenêtre $CO_i$, qui est actif à l'état bas, apparaît après la fin du signal $CI_i$, et a une durée moitié de ce dernier signal. Il est prévu pour correspondre sensiblement à la période de la fréquence $FI_{i-1}$ de la cellule d'ordre (i - 1) si le signal $CI_i$ avait une durée elle-même prévue environ égale à la période de la fréquence $FI_i$ de la cellule de rang i.

On remarque sur la partie droite du chronogramme de la figure 3, que la période u2 de la fréquence d'entrée $FI_i$ qui suit la période u1 de la même fréquence d'entrée, a été "avalée" par la cellule du fait que pendant la période u1 se trouvent présents simultanément un signal d'autorisation $CI_i$ (qui est actif à l'état bas) et un signal de programmation $D_i$ (actif à l'état haut). Au contraire dans la partie gauche du même chronogramme, on remarque que la période u3 de la fréquence d'entrée $FI_i$ n'est pas avalée parce que pendant la période précédente u4, le signal de programmation $D_i$ est à l'état bas.

Un exemple de réalisation d'une des cellules représentées à la figure 1 capable d'assurer les fonctions décrites par le chronogramme de la figure 2, est représenté schématiquement à la figure 3. La fonction de division par deux est réalisée par deux bascules $B_1$ et $B_2$, de type D, en cascade. L'entrée d'horloge CK de $B_1$ constitue l'entrée $I_i$ de

la cellule $C_i$ et reçoit le signal de fréquence $FI_i$ fourni par la sortie $O_{i-1}$ de la cellule (non représentée sur la figure) d'ordre immédiatement inférieur ($C_{i-1}$). L'entrée d'horloge CK de la deuxième bascule $B_2$ reçoit l'inverse logique du signal de fréquence $FI_i$ (à travers l'inverseur 7). La sortie $Q_1$ de la première bascule $B_1$ est connectée après inversion par un inverseur 4 à l'entrée de donnée D de la deuxième bascule $B_2$ dont la sortie $Q_2$ est rebouclée sur l'entrée D de la première bascule $B_1$ via une porte OU 1. La sortie $Q_1$ de la première bascule constitue la première sortie $O_i$ de la cellule. La cellule $C_i$ comporte en outre un étage de maintien entre la sortie $Q_2$ de la deuxième bascule $B_2$ et l'entrée de données D de la première bascule $B_1$, étage qui inclut ladite entrée de programmation $D_i$ de cette cellule, et qui est également agencé pour forcer l'état de l'entrée de données D de la première bascule $B_1$ en vue d'un avalement lorsque les signaux de programmation d'avalement $D_i$ et d'autorisation $CI_i$ sont actifs simultanément.

Plus précisément l'étage de maintien mentionné comporte une troisième bascule $B_3$ de type D, cadencée par le signal de fréquence d'entrée $FI_i$, dont l'entrée de données D reçoit l'inverse logique du signal de la sortie $Q_2$ de la deuxième bascule $B_2$ (inverseur 5) et dont la sortie est connectée à une porte OU 2, inverseuse, la deuxième entrée de cette porte OU constituant ladite deuxième entrée $CI_i$ de la cellule, dite d'autorisation d'avalement. Cette porte OU 2 a sa sortie connectée à l'entrée de données D d'une quatrième bascule $B_4$ de type D, cadencée par l'inverse du signal de fréquence d'entrée $FI_i$ et dont la sortie $Q_4$ est rebouclée sur l'entrée D de la première bascule $B_1$ du fait que cette sortie est connectée à une entrée d'une porte ET 3 dont l'autre entrée constitue ladite entrée de programmation $D_i$ de la cellule, et du fait que la sortie de la porte ET 3 est connectée à l'une des entrées de la porte OU 1, l'autre entrée de cette porte recevant le signal de la sortie $Q_2$ de la deuxième bascule $B_2$ et réalise le rebouclage déjà mentionné de cette sortie $Q_2$ sur l'entrée de la première bascule $B_1$.

De manière à produire le signal de fenêtre destiné à la cellule $C_{i-1}$, de rang immédiatement inférieur, la cellule $C_i$ comporte en outre une cinquième bascule $B_5$ de type D, cadencée par le signal de fréquence d'entrée $FI_i$, dont l'entrée de données D reçoit l'inverse logique de la sortie $Q_4$ (inverseur 6) de la quatrième bascule $B_4$ et dont la sortie $Q_5$ constitue ladite deuxième sortie $CO_i$ de la cellule, qui délivre le signal de fenêtre.

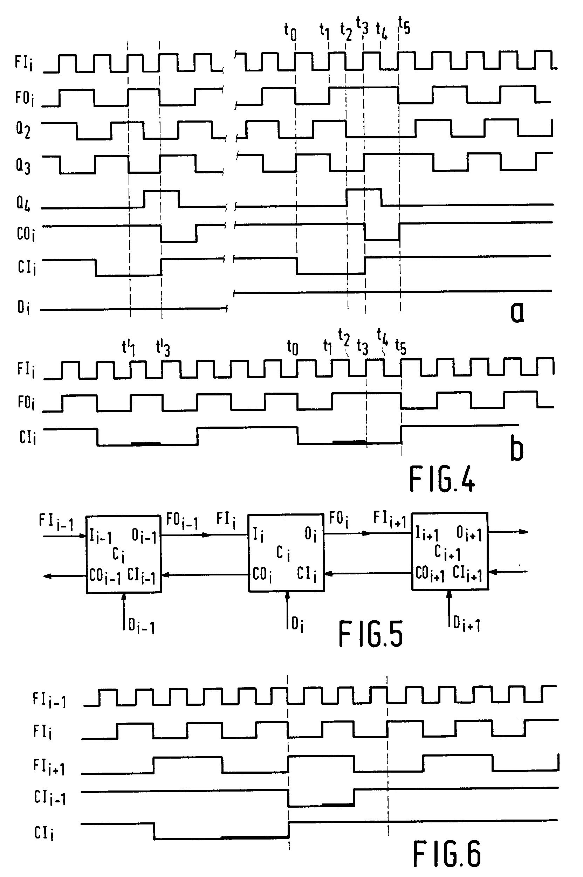

Le fonctionnement d'une cellule est explicité en liaison avec le chronogramme de la figure 4a.

Dans la partie gauche de ce chronogramme, le signal de programmation $D_i$ est au niveau 0 et verrouille donc la porte ET 3. A l'état initial, l'entrée D de la bascule $B_1$ est à 0, et l'entrée D de la bascule $B_2$ est à 1. La sortie $Q_2$ de la bascule $B_2$ passe à l'état 1 sur un front descendant de $FI_i$, état 1 qui est ramené sur l'entrée D de la bascule $B_1$ à travers la porte OU 1. Le signal $FO_i$ en sortie de la bascule $B_1$ passe à l'état 1 sur le prochain front montant de $FI_i$, ce qui entraîne un niveau 0 à l'entrée D de la deuxième bascule $B_2$ laquelle a sa sortie $Q_2$ qui passe à l'état 0 sur le prochain front descendant de $FI_i$. Ce changement d'état produit à son tour un 0 à l'entrée D de la première bascule $B_1$, qui passe à nouveau à l'état 1 sur le prochain front montant de $FI_i$, et ainsi de suite.

Dès à présent, on constate que le signal de sortie $FO_i$ correspond bien à une fréquence moitié de la fréquence d'entrée $FI_i$ et on va montrer maintenant qu'il en va de même lorsque l'entrée de programmation $D_i$ est au niveau bas.

Le signal de la sortie $Q_3$ de la troisième bascule $B_3$ se trouve décalé d'une demi-période par rapport à la fréquence du signal $FO_i$ par l'effet combiné de l'inverseur 5 et de la fréquence de cadencement $FI_i$ appliquée à l'entrée d'horloge CK de cette bascule $B_3$. D'une manière générale le signal d'autorisation $CI_i$ est au niveau 1 c'est-à-dire en dehors de la réception du signal de fenêtre émis par la cellule qui suit. Dans ce cas général, l'entrée D de la quatrième bascule $B_4$ est à zéro du fait de la porte OU 2, et sa sortie $Q_4$ reste également au niveau zéro. Lorsque se présente un signal d'autorisation, qui est actif à l'état bas, $CI_i$ passe au niveau 0, la sortie $Q_4$ passe au niveau 1 sur le premier front descendant de la fréquence d'entrée $FI_i$ qui suit le passage de la sortie $Q_3$ de la bascule $B_3$ au niveau 0. $Q_4$ repasse au niveau 0 sur le premier front descendant de la fréquence $FI_i$ qui suit le passage à l'état 1 du signal d'autorisation $CI_i$.

Le signal de fenêtre $CO_i$ délivré par la sortie $Q_5$ de la cinquième bascule $B_5$, normalement à l'état 1, passe à l'état 0 sur le premier front montant de la fréquence $FI_i$ qui suit le passage à l'état 1 de la sortie $Q_4$ de la bascule $B_4$. Il repasse à l'état 1 sur le premier front montant de la fréquence $FI_i$ qui suit le passage au niveau 0 de la sortie $Q_4$ de la bascule $B_4$ ceci résultant de la présence de l'inverseur 6 et de la fréquence de cadencement appliquée à l'entrée d'horloge CK de la bascule $B_5$. Un signal de fenêtre $CO_i$ actif à l'état bas est donc produit immédiatement après le signal d'autorisation $CI_i$ dont la durée est égale à la période de fréquence d'entrée $FI_i$ de la cellule.

L'entrée de programmation $D_i$ étant à l'état bas dans la partie gauche de la figure 4a, la boucle de maintien $B_4$, 3, 1 n'est pas active puisque bloquée par la porte ET 3.

La partie droite du chronogramme de la figue 4a décrit le cas ou la commande de programma-

tion $D_i$ est activée au niveau haut en vue de l'avalement d'une période de la fréquence d'entrée $FI_i$ de la cellule. Il s'ensuit que le niveau haut de la sortie $Q_4$ de la quatrième bascule $B_4$ est rebouclé à l'entrée de la première bascule $B_1$ par l'effet de la porte ET 3. La boucle de maintien est maintenant en état de fonctionnement et lors du prochain front ascendant de la fréquence d'entrée $FI_i$ (instant $t_3$), la première bascule $B_1$ ne change pas d'état et sa sortie $FO_i$ reste au niveau haut. Cependant la sortie $Q_4$ de la quatrième bascule $B_4$ retombe au niveau bas sur le front descendant de la fréquence $FI_i$ qui suit immédiatement l'instant $t_3$ c'est-à-dire à l'instant $t_4$. Le signal de sortie $FO_i$ pourra donc passer à nouveau au niveau bas sur le front ascendant $FI_i$ qui suit immédiatement $t_4$ c'est-à-dire l'instant $t_5$. On constate que le signal de sortie $FO_i$ a donc sauté une période durant un temps égal à une période du signal d'entrée $FI_i$, ce qui correspond à cet instant à une division par trois au lieu d'une division par deux soit encore une division par 2 + $D_i$ ($D_i$ valant soit 1, soit 0). Cette opération appelée par ailleurs avalement d'une période de la fréquence d'entrée d'une cellule, est bien entendu répercutée sur les signaux de la sortie $Q_2$ de la deuxième bascule $B_2$ et sur la sortie $Q_3$ de la troisième bascule $B_3$. Par contre les signaux $Q_4$ de la quatrième bascule $B_4$ et $CO_i$ à la sortie de la cinquième bascule $B_5$ restent les mêmes que dans le cas précédent, correspondant à la partie gauche du chronogramme, pour lequel $D_i$ = 0. Le signal de fenêtre $CO_i$ est donc généré dans tous les cas.

Ces considérations permettent de déterminer quelles sont les conditions temporelles qui doivent être respectées par le signal d'autorisation d'avalement $CI_i$ appliqué à la cellule, pour obtenir le saut d'un intervalle correspondant à une période de la fréquence d'entrée $FI_i$ soit encore l'avalement d'une période induisant ponctuellement une division par trois au lieu d'une division par deux de cette fréquence $FI_i$. On se reportera à cet effet au chronogramme de la figure 4b.

En effet, il est à noter que le schéma de réalisation donné à la figure 3 ne représente qu'un exemple d'une organisation possible d'une cellule programmable selon l'invention. D'autres moyens équivalents pourraient être mis en oeuvre dans la mesure où ils procurent le même résultat.

Pour plus de clarté le chronogramme de la figure 4b ne reprend que les signaux $FI_i$, $FO_i$ et $CI_i$. Le signal de sortie $FO_i$ est au niveau haut entre l'instant $t'_1$ et l'instant $t'_3$ ($t_1$, $t_3$) pendant une période du signal d'entrée $FI_i$. Quand l'entrée de programmation $D_i$ est activée au niveau haut pour programmer un avalement, l'état haut du signal de sortie $FO_i$ est prolongé jusqu'à un instant $t_5$, soit pendant une période supplémentaire du signal d'entrée $FI_i$. Le signal de sortie $Q_4$ de la quatrième

bascule $B_4$ permet une opération d'avalement par le maintien d'un niveau 1 sur l'entrée D de la première bascule $B_1$ lors d'un front montant de la fréquence d'entrée $FI_i$ (à l'instant $t_3$). Or le signal de la sortie $Q_4$ de la bascule $B_4$ passe au niveau haut sur le front descendant du signal $FO_i$ lorsque le signal $Q_3$ et le signal $CI_i$ sont tous les deux à 0. Il est donc nécessaire que le signal $CI_i$ soit déjà au niveau 0 sur le front descendant de la fréquence d'entrée $FI_i$ à l'instant $t_2$ qui précède l'instant $t_3$. Il faut donc en pratique que le signal $CI_i$ passe au niveau 0 une demi-période de $FI_i$ avant l'instant $t_2$ c'est-à-dire à l'instant $t_1$. D'autre part, pour obtenir un avalement à coup sûr par une montée au niveau 1 de la sortie $Q_4$ de la quatrième bascule $B_4$, il est nécessaire que le signal $CI_i$ soit encore au niveau bas une demi-période de $FI_i$ au-delà de l'instant $t_2$ c'est-à-dire à l'instant $t_3$. En d'autres termes, l'opération d'avalement se produit à l'instant $t_3$ à la suite du changement d'état de la bascule $B_4$, lequel doit être déjà effectif à l'instant $t_2$. Ainsi la durée minimale de $t_1$ à $t_3$ du signal $CI_i$ à 0 qui permet d'obtenir un avalement d'une période de $FI_i$ et représentée en trait plus épais à la figure 4b, correspond à une demi-période de $FI_i$ de part et d'autre de l'instant $t_2$.

La durée maximale du signal d'autorisation d'avalement $CI_i$ s'étend d'une période de $FI_i$ de part et d'autre de la durée minimale et donc de l'instant $t_0$ à l'instant $t_5$. En effet, si le signal $CI_i$ était encore au niveau 0 au-delà de l'instant $t_5$, il y aurait un risque de remontée au niveau 1 de la sortie $Q_4$ de la quatrième bascule $B_4$ une demi-période de la fréquence $FI_i$ après l'instant $t_5$ et donc de produire un nouveau saut d'intervalle au cas où le signal $D_i$ est encore programmé au niveau 1. Au contraire, si le signal $CI_i$ était déjà au niveau 0 sur le front descendant de la fréquence $FI_i$ qui précède l'instant $t_0$, soit une période et demi de $FI_i$ avant $t_1$, il y aurait alors un risque de passage au niveau 1 de la sortie $Q_4$ de la quatrième bascule $B_4$ ce qui entraînerait un avalement prématuré et supplémentaire.

De l'analyse qui précède, on tire la conclusion que le signal d'autorisation $CI_i$ a une durée comprise entre 1 et 3 fois la période de la fréquence d'entrée $FI_i$ de la cellule $C_i$. Or, le signal d'autorisation d'avalement $CI_i$ n'est autre que le signal dit de fenêtre émis par la cellule qui suit la cellule $C_i$, c'est-à-dire la cellule d'indice i + 1. Or la cellule $C_{i+1}$ a une fréquence d'entrée $FI_{i+1}$ qui est moitié de la fréquence $FI_i$, ce qui a pour conséquences que le signal de fenêtre $CO_i$ généré par la cellule de rang i doit présenter une durée moitié de celle définie pour son propre signal d'autorisation $CI_i$. En pratique, on en vient à la condition que le signal de fenêtre généré par une cellule de rang i doit présenter une durée comprise entre 0,5 et 1,5 fois la période de la fréquence d'entrée $FI_i$ de cette même cellule. On peut constater dès à présent que les conditions de durée du signal d'autorisation $CI_i$ expriment une précision peu exigeante ce qui n'était pas le cas selon l'art antérieur.

Les figures 5 et 6 sont relatives au fonctionnement de trois cellules adjacentes $C_{i-1}$, $C_i$ et $C_{i+1}$ du type de celle décrite à la figure 3. La figure 5 représente les liens entre les trois cellules précitées tandis que la figure 6 représente un chronogramme des signaux FI et CI desdites cellules. En dehors d'une opération d'avalement, le signal de fréquence d'entrée $FI_i$ de la cellule $C_i$ a une fréquence moitié de celle du signal de fréquence d'entrée $FI_{i-1}$. De même, le signal d'entrée $FI_{i+1}$ a une fréquence moitié de celle du signal d'entrée $FI_i$.

Le signal d'autorisation $CI_i$ de la cellule $C_i$, actif à l'état bas, présente une durée qui est le double de la période du signal de la fréquence d'entrée $FI_i$ de la même cellule $C_i$ et il commence une période de $FI_i$ avant le début de la fenêtre minimale indiquée par un trait renforcé. Le signal d'autorisation $CI_{i-1}$ appliqué à la cellule $C_{i-1}$ (qui n'est autre que le signal de fenêtre $CO_i$ émis par la cellule $C_i$) a une durée active à l'état bas égale à deux périodes de la fréquence d'entrée $FI_{i-1}$ de la cellule $C_{i-1}$. On vérifie en effet sur la figure 4a que le signal d'autorisation $CI_{i-1}$ a une durée moitié de celle du signal d'autorisation $CI_1$ de la cellule $C_i$. En définitive, les signaux d'entrée $FI_{i-1}$, $FI_i$, $FI_{i+1}$, sont engendrés à une fréquence successive de moins en moins élevée tandis que les signaux d'autorisation, engendrés successivement, dans l'ordre inverse $CI_{i+1}$, $CI_i$ et $CI_{i-1}$, sont à fréquence de plus en plus élevée. Par ailleurs, une cellule quelconque présente toujours le même rapport (ici un rapport 2) entre la période de son signal d'autorisation $CI_i$ et celle de sa fréquence d'entrée $FI_i$.

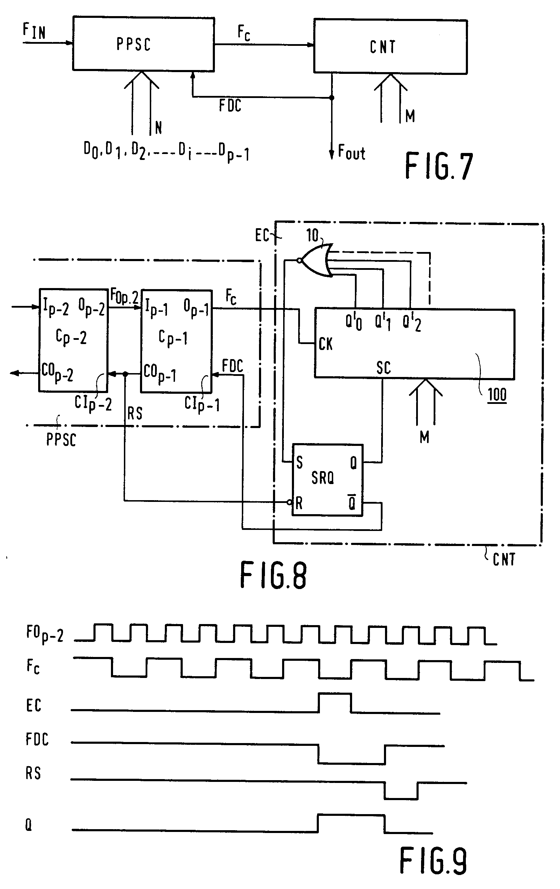

La figure 7 représente schématiquement un circuit diviseur de fréquence selon l'invention. Il utilise un prédiviseur PPSC tel que décrit précédemment associé à un compteur CNT. Le prédiviseur PPSC correspond au circuit décrit à la figure 1. Il reçoit une fréquence d'entrée à diviser $F_{IN}$ et produit un signal de sortie $F_c$ appliqué à l'entrée de décomptage du compteur CNT. Le compteur CNT est chargé par un compte total M et il fonctionne cycliquement (M = une variable entière plus grande que 1). Le compteur CNT produit un signal de fin de cycle FDC appliqué à l'entrée d'autorisation $CI_{p-1}$ de la p^{ième} cellule, c'est-à-dire la cellule de sortie du prédiviseur, de rang (p - 1). L'ensemble des signaux de programmation $(D_{p-1}..... D_i...... D_1, D_0)$ forment un nombre binaire de valeur N tel que :

$$N = D_0 + 2 D_1 + 2^2 D_2 + .... 2^i D_i + .... + 2^{p-1} D_{p-1} \quad (1)$$

Lorsque le signal FDC passe à l'état 0, le prédiviseur PPSC passe en mode de programmation, les signaux d'autorisation $CI_i$ et de fenêtre $CO_i$ remontent les cellules à contre courant comme il a été décrit ci-dessus, en induisant un seul avalement d'une période de $F_i$ dans chacune des cellules pour lesquelles $D_i$ est au niveau 1.

Lorsque le signal de fin de cycle FDC est à l'état haut (égal 1), le rapport de division du prédiviseur PPSC est égal à $2^p$ puisqu'il comporte p cellules de division par 2. Lorsque le signal de fin de cycle FDC est au contraire à l'état bas (= 0), le prédiviseur PPSC passe en mode de programmation. Les calculs qui suivent vont permettre de déterminer quel est le nombre de périodes de la fréquence d'entrée $F_{IN}$ du prédiviseur PPSC nécessaires pour former une période complète de sortie du signal $F_c$ à la sortie du prédiviseur PPSC. Pour obtenir une période du signal de sortie FC du prédiviseur, il faut :
à l'entrée de la cellule de rang p - 1 :
$2 + D_{p-1}$ périodes,
à l'entrée de la cellule de rang p - 2 :

$$2 (2 + D_{p-1}) + D_{p-2}$$

à l'entrée de la cellule de rang p - 3 :

$$2 (2 + (2 + D_{p-1}) + D_{p-2}) + D_{p-3}$$

soit encore $2^2(2 + D_{p-1}) + 2 D_{p-2} + D_{p-3}$
à l'entrée de la cellule de rang p - 4 :

$$2^3 (2 + D_{p-1}) + 2^2 D_{p-2} + 2 D_{p-3} + D_{p-4}$$

et à l'entrée de la cellule de rang O
c est-à-dire à l'entrée du prédiviseur PPSC :

$$2^{p-1} (2 + D_{p-1}) + 2^{p-2} D_{p-2} + ... + 2 D_1 + D_0$$

ce qui peut s'écrire :

$$2^p + (2^{p-1} D_{p-1} + 2^{p-2} D_{p-2} + ... + 2 D_1 + D_0)$$

soit encore, compte tenu de la relation (1) :

$$2^p + N \quad (2)$$

Pour l'ensemble du prédiviseur PPSC, un cycle en mode de programmation correspond donc à un avalement de N fois la période de $F_{IN}$. Le fonctionnement du circuit diviseur de fréquence représenté à la figure 7 est alors le suivant :

Dans un premier temps, le compteur CNT est chargé au compte M et le signal FDC est au niveau 1. Le prédiviseur PPSC divise alors dans un mode non programmé où toutes les cellules ont un rapport de division par 2. Ceci se poursuit pendant (M - 1) périodes du signal de sortie $F_c$ du prédiviseur jusqu'à ce que le compteur CNT atteigne le compte 0. A ce moment là, le signal de fin de cycle FDC passe à l'état 0, ce qui active le prédiviseur PPSC en mode de programmation, et valide les entrées de programmation $D_0,... D_i.... D_{p-1}$. A partir de ce même instant, le compteur CNT peut être rechargé avec le compte M qui peut être égal ou différent du compte M précédent. Comme on va le voir, on dispose d'un temps égal à la période de la fréquence $F_c$ de sortie du prédiviseur PPSC (en mode programmé) pour effectuer cette opération.

Pendant les (M - 1) premières périodes du signal de sortie $F_c$ du prédiviseur, on obtient une division de la fréquence d'entrée $F_{IN}$ par $2^p$, ce qui correspond à $(M - 1)\, 2^p$ périodes d'horloge $F_{IN}$.

Pendant la période restante ($M^{ème}$ période), le mode programmé du prédiviseur PPSC fournit une division par $2^p + N$ ce qui correspond à $2^p + N$ périodes de la fréquence de l'horloge $F_{IN}$.

On a donc une période complète à la sortie $F_{OUT}$ du circuit diviseur de fréquence qui correspond à :

$(M - 1)\, 2^p + 2^p + N$, soit encore $M\, 2^p + N$ périodes de la fréquence d'entrée $F_{IN}$.

Le rapport de division R devient donc :

$$R = M\, 2^p + N.$$

La figure 8 permet de décrire avec plus de détails comment est agencé le couplage entre le compteur CNT et la sortie du prédiviseur PPSC et la figure 9 présente un chronogramme des signaux correspondants. Pour faciliter la compréhension, le compteur CNT a été représenté comme formé de trois parties, une porte OU inverseuse 10, un dispositif de décomptage proprement dit 100 et une bascule SRQ de type SR. Le dispositif de décomptage 100 comporte une entrée de cadencement CK, une entrée de stockage du nombre M à décompter, une entrée de validation SC du chargement du compte M et des sorties bits par bits $Q'_0$, $Q'_1$, $Q'_2$... connectées en parallèle aux entrées de la porte OU 10. La sortie non inversée Q de la bascule SRQ est connectée à l'entrée de validation SC du dispositif de décomptage 100, la sortie inversée $\overline{Q}$ de cette bascule est connectée à l'entrée $CI_{p-1}$ en tant que signal de fin de cycle FDC, l'entrée S de la bascule SRQ est connectée à la sortie inverseuse de la porte OU 10 et l'entrée inverseuse de la bascule SRQ est connectée à la liaison $CO_{p-1}$, $CI_{p-2}$ laquelle fournit le signal de repositionnement RS de la bascule SRQ. Lorsque le compte M est décompté à zéro, toutes les sorties $Q'_0$, $Q'_1$, $Q'_2$... sont à zéro ce qui donne à la sortie de la porte OU inverseuse 10 un signal EC à l'état 1, provoque par l'intermédiaire de la bascule SRQ une validation SC de chargement du compte M, et dès lors, l'une au moins des sorties Q' du dispositif de décomptage 100 passe à l'état 1 de sorte que le signal de sortie de la porte OU 10 redescend à zéro. Au même instant, ladite bascule SRQ envoie un signal de sortie inversé $\overline{Q}$ en tant que signal de fin de cycle FDC à l'entrée $CI_{p-1}$ du prédiviseur PPSC. La cellule de sortie de rang (p - 1) du prédiviseur PPSC va générer un signal de fenêtre conformément à ce qui a déjà été décrit. Ce même signal est utilisé en tant que signal de repositionnement RS appliqué sur une entrée inverseuse R de la bascule SRQ laquelle provoque un changement d'état du signal SC (état bas) ce qui débloque le chargement du compte M et fait repasser le dispositif de décomptage 100 en mode de décomptage. Conformément à l'exemple indiqué à la figure 6, le signal RS a une durée moitié de celle du signal de fin de cycle FDC.

On remarquera qu'il n'est pas nécessaire d'utiliser la cellule de sortie $C_{p-1}$ pour générer le signal RS. Celui-ci pourrait être encore produit à partir d'un circuit mono-stable non représenté qui utiliserait en entrée le front montant du signal de la sortie $\overline{Q}$ de la bascule SRQ et produirait une impulsion RS d'une durée sensiblement égale à la moitié de la durée du signal de fin de cycle FDC.

Pour bien comprendre les avantages du circuit diviseur de fréquence selon l'invention, il est à remarquer que les liaisons entre le compteur CNT et le prédiviseur PPSC travaillent toutes à des fréquences qui sont les plus basses et correspondent à la fréquence de sortie $F_c$ du prédiviseur PPSC. De plus, il est à noter que le signal de fin de cycle FDC peut être, d'une manière générale, généré à tout moment d'un cycle de comptage. La propagation à contre courant du signal d'autorisation d'avalement peut même chevaucher deux périodes du cycle de décomptage de M à la condition que le signal de fin de cycle FDC soit toujours produit au même moment de ce cycle de décomptage, et une seule fois par cycle.

Un circuit diviseur de fréquence selon l'invention peut être utilisé avantageusement dans un synthétiseur de fréquence notamment pour transformer la sortie d'un oscillateur commandé par tension (VCO) à une fréquence de l'ordre de 1 GHz en un signal de fréquence relativement basse par division dans un rapport R variable par pas de une unité, comparé à une fréquence stable délivrée par un oscillateur à quartz. La variation du rapport de division R permettant la sélection de différents canaux de réception.

**Revendications**

**1.** Circuit diviseur de fréquence programmable comportant: p cellules de division de fréquence disposées en cascade, chacune de ces cellules représentant un rang de division i, pour i prenant l'une des valeurs de 0 à (p-1), et étant susceptible d'être commutée entre un mode de division par deux, dit mode normal, et un mode de division par trois, dit mode programmé, une cellule de rang quelconque i comportant une première entrée ($I_i$) pour un signal de fréquence d'entrée ($FI_i$) et une première sortie ($O_i$) pour un signal de fréquence de sortie ($FO_i$) à appliquer à la première entrée ($I_{i+1}$) de la cellule suivante de rang (i + 1), une deuxième entrée ($CI_i$) pour un signal d'autorisation du mode programmé, une troisième entrée ($D_i$) pour un signal de programmation, et une deuxième sortie ($CO_i$) pour un signal de fenêtre, des moyens étant prévus pour engendrer ce signal de fenêtre à partir du signal d'autorisation reçu sur la deuxième entrée ($CI_i$) de la cellule i et ce signal de fenêtre étant appliqué à la deuxième entrée ($CI_{i-1}$) de la cellule (i-1) de rang inférieur, en tant que signal d'autorisation,
caractérisé en ce que les moyens pour engendrer le signal de fenêtre sont agencés pour que ce signal soit émis à partir de l'instant où le signal d'autorisation reçu par la même cellule i, retourne à son état logique inactif, et en ce qu'aux p cellules - qui constituent un prédiviseur pour le circuit diviseur de fréquence - sont associés des moyens de comptage pour effectuer un premier comptage et un second comptage respectivement d'un premier nombre et d'un second nombre de périodes de la fréquence de sortie dudit prédiviseur, la deuxième entrée ($CI_{p-1}$) de la pème cellule recevant un signal d'autorisation délivré par les moyens de comptage, qui est déduit de l'achèvement dudit premier comptage, et l'accomplissement de ces premier et second comptages constituant une période de sortie du circuit diviseur.

2. Circuit diviseur selon la revendication 1, caractérisé en ce que lesdits moyens de comptage étant chargés par un compte total M (avec M = variable entière, plus grande que 1) ledit premier nombre est égal à (M - 1) durant le comptage duquel les p cellules du prédiviseur fonctionnent en mode non programme et les entrées de programmation ($D_i$) peuvent être rechargées tandis que ledit second nombre est égal à 1, correspondant à une période de la fréquence de sortie du prédiviseur dont les cellules fonctionnent alors en mode programmé, période durant laquelle les moyens de comptage sont rechargés au compte M.

3. Circuit diviseur selon l'une des revendications 1 ou 2, caractérisé en ce que le signal de fenêtre généré par une cellule de rang i, présente une durée comprise entre 0,5 et 1,5 fois la période de la fréquence d'entrée ($FI_i$) de cette même cellule.

4. Circuit diviseur selon la revendication 3, caractérisé en ce que chacune des cellules du prédiviseur comporte une première (B1) et une deuxième (B2) bascule de type D en cascade et cadencées respectivement par le signal de fréquence d'entrée ($FI_i$) de cette cellule, et son inverse logique, en ce que la sortie (Q2) de la deuxième bascule (B2) est rebouclée sur l'entrée de données (D) de la première bascule (B1), la sortie (Q1) de la première bascule constituant la première sortie ($O_i$) de la cellule, et en ce qu'elle comporte un étage de maintien entre la sortie (Q2) de la deuxième bascule et l'entrée de données (D) de la première bascule (B1) qui inclut ladite entrée de programmation ($D_i$) de la cellule, étage de maintien agencé pour forcer l'état de l'entrée de données (D) de la première bascule (B1) en vue d'un avalement lorsque les signaux de programmation d'avalement ($D_i$) et d'autorisation ($CI_i$) sont actifs simultanément.

5. Circuit diviseur selon la revendication 4, caractérisé en ce que l'étage de maintien comporte une troisième bascule D (B3) cadencée par le signal de fréquence d'entrée ($FI_i$), dont l'entrée de données (D) reçoit l'inverse logique du signal de la sortie (Q2) de la deuxième bascule (B2) et dont la sortie est connectée à une première porte OU (2), inverseuse, la deuxième entrée de cette porte OU constituant ladite deuxième entrée ($CI_i$) de la cellule, laquelle porte OU (2) a sa sortie connectée à l'entrée de données (D) d'une quatrième bascule D (B4) cadencée par l'inverse du signal de fréquence d'entrée ($FI_i$) et dont la sortie (Q4) est rebouclée sur l'entrée (D) de la première bascule (B1) du fait que cette sortie est connectée à une première entrée d'une porte ET (3) dont l'autre entrée constitue ladite entrée de programmation ($D_i$) de la cellule, et que la sortie de la porte ET (3) est connectée à une première entrée d'une deuxième porte OU (1), dont la sortie est connectée à l'entrée (D) de la première bascule (B1), la deuxième entrée de la deuxième porte OU (1) recevant le signal de la sortie (Q2) de la deuxième bascule (B2) pour réaliser ledit rebouclage de cette sortie (Q2) sur l'entrée de la première bascule (B1).

6. Circuit diviseur selon la revendication 5, caractérisé en ce que chaque cellule du prédiviseur comporte en outre une cinquième bascule D (B5) cadencée par le signal de fréquence d'entrée ($FI_i$), dont l'entrée de données (D) reçoit l'inverse logique de la sortie (Q4) de la quatrième bascule (B4), la sortie (Q5) de la cinquième bascule (B5) constituant ladite deuxième sortie ($CO_i$) de la cellule.

7. Circuit diviseur selon l'une quelconque des revendications 1 à 6, caractérisé en ce que lesdits moyens de comptage sont constitués d'un compteur cyclique (CNT) ayant une entrée de décomptage reliée à la sortie ($O_{p-1}$) de la $p^{ème}$ cellule du prédiviseur, et une sortie de décompte activant l'entrée d'autorisation ($CI_{p-1}$) de la $p^{ème}$ cellule du prédiviseur lorsque ledit décompte est égal à zéro.

FIG.1

FIG.2

FIG.3

FIG.4

FIG.5

FIG.6

FIG.7

FIG.8

FIG.9

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| D,A | DE-A-4 008 385 (NIHON MUSEN K.K.)<br>* page 2, ligne 43 - page 3, ligne 51; figures 1-3 *<br>--- | 1-7 | H03K23/66 |
| A | US-A-4 575 867 (HOGUE)<br>* le document en entier *<br><br>----- | 1 | |
| | | | **DOMAINES TECHNIQUES RECHERCHES (Int. Cl.5 )**<br><br>H03K |

Le présent rapport a été établi pour toutes les revendications

| Lieu de la recherche | Date d'achèvement de la recherche | Examinateur |
|---|---|---|
| LA HAYE | 04 SEPTEMBRE 1992 | FEUER F.S. |